# EUROPEAN PATENT APPLICATION

(11) **EP 4 549 613 A1**
(43) Date of publication of application: **07.05.2025**
(21) Application number: 24200993.4
(22) Date of filing: 18.09.2024
(51) Int. Cl.: C23C 16/44, C23C 16/455, C23C 16/448

(54) **HIGH PRESSURE GASEOUS HYDROGEN OXIDE PROVIDING DEVICE, AND HIGH PRESSURE SUBSTRATE PROCESSING APPARATUS AND METHOD USING THE SAME**

(30) Priority: 21.09.2023 KR 20230126438
(71) Applicant: HPSP Co., Ltd., Hwaseong-si, Gyeonggi-do 18449 (KR)
(72) Inventor: Lee, Si Hyung, 18449 Hwaseong-si, Gyeonggi-do, (KR); Lim, Kunyoung, 18449 Hwaseong-si, Gyeonggi-do, (KR); Min, Bin hong, 18449 Hwaseong-si, Gyeonggi-do, (KR); Yoon, Hyeseong, 18449 Hwaseong-si, Gyeonggi-do, (KR)
(74) Representative: von Bülow & Tamada

(57) **Abstract**

Disclosed are a high pressure gaseous hydrogen oxide providing device, and a high pressure substrate processing apparatus and method using the same. The high pressure substrate processing method includes reacting a hydrogen gas and an oxygen gas, obtaining a generated hydrogen oxide having a first pressure, converting the generated hydrogen oxide into a processed gaseous hydrogen oxide having a second pressure higher than the first pressure and an atmospheric pressure, and acting the processed gaseous hydrogen oxide on a substrate to be processed in a processing area.

## Description

### BACKGROUND

### 1. FIELD

The present disclosure relates to a high pressure substrate processing apparatus and method, and a high pressure gaseous hydrogen oxide providing device used therefor.

### 2. DESCRIPTION OF RELATED ART

In general, during the manufacturing process of semiconductor devices, various processing is performed on a semiconductor substrate. Examples of the processing include oxidation, nitration, ion implantation, and deposition processes. There is also a hydrogen or deuterium heat treatment process to improve interface characteristics of the semiconductor device.

The manufacturing process may be largely divided into a vacuum process and a high-pressure process depending on a pressure of gas acting on the substrate. While the former has a lower pressure than an atmospheric pressure, the latter has a higher pressure than the atmospheric pressure.

The two processes have different characteristics and features, so what is not a problem in one process may cause a big problem in another process. For example, when using vapor in wet oxidation, etc., unlike the vacuum process, impurities may be a big problem in the high-pressure process.

The above-described background art is technical information retained by the inventor to derive embodiments of the present disclosure or acquired by the inventor while deriving the present disclosure, and thus should not be construed as art that was publicly known prior to the filing date of the present application.

### SUMMARY

The present disclosure provides a high pressure gaseous hydrogen oxide providing device capable of effectively removing impurities in a process using high pressure gaseous hydrogen oxide to prevent quality defects in a substrate processed through the process, and a high pressure substrate processing apparatus and method using the same.

The present disclosure provides a high pressure gaseous hydrogen oxide providing device capable of preventing a generation of unreacted gas during a generation of high pressure gaseous hydrogen oxide or removing the generated unreacted gas to prevent the risk of explosion, and a high pressure substrate processing apparatus and method using the same.

According to an aspect of the present disclosure, a high pressure substrate processing method includes: reacting a hydrogen gas and an oxygen gas; obtaining a generated hydrogen oxide having a first pressure; converting the generated hydrogen oxide into a processed gaseous hydrogen oxide having a second pressure higher than the first pressure and an atmospheric pressure; and allowing the processed gaseous hydrogen oxide to act on a substrate to be processed in a processing area.

The converting of the generated hydrogen oxide into the processed gaseous hydrogen oxide having the second pressure higher than the first pressure and the atmospheric pressure may include injecting an auxiliary gas into the processing area in addition to the gaseous hydrogen oxide obtained from the generated hydrogen oxide so that the gaseous hydrogen oxide obtained from the generated hydrogen oxide in the processing area reaches the second pressure.

The converting of the generated hydrogen oxide into the processed gaseous hydrogen oxide having the second pressure higher than the first pressure and the atmospheric pressure may include: obtaining a liquid hydrogen oxide from the generated hydrogen oxide; pressurizing the liquid hydrogen oxide; and vaporizing the pressurized liquid hydrogen oxide to obtain the processed gaseous hydrogen oxide.

According to another aspect of the present disclosure, a high pressure substrate processing apparatus includes: an internal chamber that is formed to accommodate a processing gas including a processed gaseous hydrogen oxide and having a processing pressure higher than an atmospheric pressure, and a substrate to be processed by the processing gas; an external chamber that is formed to accommodate the internal chamber and a protective gas having a protection pressure set in relation to the processing pressure; a generation module that is formed to react a hydrogen gas and an oxygen gas to generate a generated hydrogen oxide having a generation pressure lower than the processing pressure; and a conversion module that is formed to pressurize the generated hydrogen oxide to convert the generated hydrogen oxide into the processed gaseous hydrogen oxide having the processing pressure.

The conversion module may include an auxiliary gas line that is formed to inject an auxiliary gas into the internal chamber in addition to gaseous hydrogen oxide obtained from the generated hydrogen oxide so that the gaseous hydrogen oxide obtained from the generated hydrogen oxide in the internal chamber reaches the processing pressure.

The conversion module may include a vaporization heater that is formed to vaporize liquid hydrogen oxide obtained from the generated hydrogen oxide to generate the processed gaseous hydrogen oxide.

One of the generation module and the conversion module may further include a water tank that is formed to accommodate the liquid hydrogen oxide obtained from the generated hydrogen oxide and communicates with the vaporization heater.

The conversion module may further include a pump that is disposed between the water tank and the heater and formed to pressurize and pump the liquid hydrogen oxide obtained from the generated hydrogen oxide toward the internal chamber.

The conversion module may further include: a discharge line that is formed to discharge an unreacted gas not participating in the reaction among the hydrogen gas and the oxygen gas from the water tank; and an injection line that is formed to inject a purge gas for purging the unreacted gas into the water tank.

The high pressure substrate processing apparatus may further include a heating module that is disposed within the external chamber to heat the processing gas to a processing temperature, in which the vaporization heater may be disposed within the external chamber.

According to still another aspect of the present disclosure, a high pressure gaseous hydrogen oxide providing device for a high pressure substrate processing apparatus includes: a generation module that is formed to react a hydrogen gas and an oxygen gas to generate generated hydrogen oxide having a generation pressure lower than a processing pressure for processing a substrate to be processed in the high pressure substrate processing apparatus; and a conversion module that is formed to pressurize the generated hydrogen oxide to convert the generated hydrogen oxide into the processed gaseous hydrogen oxide having the processing pressure, in which the processing pressure is a pressure higher than an atmospheric pressure.

The conversion module may include an auxiliary gas line that is formed to inject auxiliary gas into a processing area in which the substrate to be processed is disposed in the high pressure substrate processing apparatus in addition to gaseous hydrogen oxide obtained from the generated hydrogen oxide so that the gaseous hydrogen oxide obtained from the generated hydrogen oxide in the processing area reaches the processing pressure.

The conversion module may include a vaporization heater that is formed to vaporize liquid hydrogen oxide obtained from the generated hydrogen oxide to generate the processed gaseous hydrogen oxide.

One of the generation module and the conversion module may further include a water tank that is formed to accommodate the liquid hydrogen oxide obtained from the generated hydrogen oxide and communicates with the vaporization heater.

The conversion module may further include a pump that is disposed between the water tank and the vaporization heater and formed to pressurize and pump the liquid hydrogen oxide obtained from the generated hydrogen oxide toward the internal chamber.

### BRIEF DESCRIPTION OF DRAWINGS

FIG. 1 is a conceptual diagram of a high pressure substrate processing apparatus according to one embodiment of the present disclosure.
FIG. 2 is a block diagram for describing a control configuration of the high pressure substrate processing apparatus of FIG. 1.
FIG. 3 is a conceptual diagram illustrating a generation module of FIG. 2.
FIG. 4 is a conceptual diagram illustrating a generation module and a conversion module according to another embodiment of the present disclosure.
FIG. 5 is a cross-sectional diagram illustrating a water tank of FIG. 4.
FIG. 6 is a conceptual diagram illustrating a generation module and a conversion module according to another embodiment of the present disclosure.
FIG. 7 is a flowchart illustrating a high pressure substrate processing method according to still another embodiment of the present disclosure.
FIG. 8 is a flowchart illustrating a specific processing example related to one step of FIG. 6.
FIG. 9 is a flowchart illustrating another specific processing example related to one step of FIG. 6.

### DETAILED DESCRIPTION

Hereinafter, exemplary embodiments of the present disclosure will be described in detail with reference to the accompanying drawings.

However, the present disclosure is not limited to embodiments set forth herein, but may be modified variously and implemented in various different forms. However, the embodiment is provided to ensure that the disclosure of the present disclosure is complete and to fully inform those skilled in the art of the scope of the invention. Therefore, the present disclosure is not limited to the embodiments disclosed below, but it should be understood that substitution or addition of components of one embodiment and components of another embodiment include all changes, equivalents, and substitutions included in the technical spirit and scope of the present disclosure.

It should be understood that the accompanying drawings are provided only in order to allow exemplary embodiments of the present disclosure to be easily understood, and the spirit of the present disclosure is not limited by the accompanying drawings, but includes all the modifications, equivalents, and substitutions included in the spirit and the scope of the present disclosure. In the drawings, components may be expressed exaggeratedly large or small in size or thickness for convenience of understanding, etc., but the scope of protection of the present disclosure should not be construed as limited.

Terms used in the present specification are used only in order to describe specific implementation examples or embodiments rather than limiting the present disclosure. Singular forms are intended to include plural forms unless the context clearly indicates otherwise. In the specification, terms such as ~include, -consist of, etc., are intended to designate the existence of features, numbers, steps, operations, components, parts, or a combination thereof described in the specification. Also, it should be understood that terms such as "~include" and "~consist of" do not preclude the existence or addition possibility of one or more other features or numbers, steps, operations, components, parts, or combinations thereof.

The terms including ordinal numbers such as 'first' and 'second' may be used to describe various components, but these components are not limited by these terms. The terms are used to distinguish one component from another component.

It is to be understood that when one element is referred to as being "connected to/communicate with" or "coupled to" another element, it may be connected directly to or coupled directly to another element or be connected to/communicate with or coupled to another element, having the other element intervening therebetween. On the other hand, it should be understood that when one element is referred to as being "connected directly to/communicate with" or "coupled directly to" another element, it may be connected to or coupled to another element without the other element interposed therebetween.

When a component is referred to as being "on top" or "below" another component, it should be understood that not only is it disposed directly on top of other components, but there may also be other components in between.

Unless indicated otherwise, it is to be understood that all the terms used in the specification including technical and scientific terms have the same meaning as those that are generally understood by those who skilled in the art. Terms generally used and defined by a dictionary should be interpreted as having the same meanings as meanings within a context of the related art and should not be interpreted as having ideal or excessively formal meanings unless being clearly defined otherwise in the present specification.

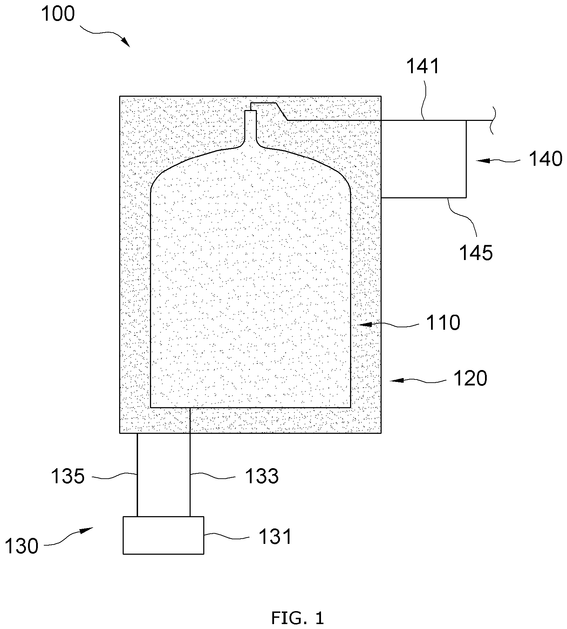

FIG. 1 is a conceptual diagram of a high pressure substrate processing apparatus according to one embodiment of the present disclosure.

Referring to this drawing, a high pressure substrate processing apparatus 100 may include an internal chamber 110, an external chamber 120, a gas supply module 130, and a gas exhaust module 140.

The internal chamber 110 forms a processing area that accommodates a substrate for processing. The internal chamber 110 may be made of a non-metallic material, such as quartz, to reduce contamination in a high temperature and high pressure working environment. Although simplified in the drawing, an inner door (not illustrated) that opens the processing area is provided at a bottom of the internal chamber 110. As the inner door is lowered, the processing area is opened, and the substrate may be introduced into the processing area. According to an operation of a heater (not illustrated) disposed outside the internal chamber 110, the temperature of the internal chamber 110 may reach several hundred to thousand 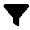 C. The substrate may be, for example, a wafer for semiconductor manufacturing. The wafer may be made of, for example, Si, SiC, GaN, or the like. The substrate is not limited to the wafer, and any substrate can be used as long as it is a base structure for making a circuit. For example, the substrate may also include glass for making a display. The holder may be a boat capable of stacking a substrate to be processed in multiple layers.

The external chamber 120 is disposed to accommodate the internal chamber 110. Unlike the internal chamber 110, the external chamber 120 is free from concerns about contamination of the substrate, and may be made of a metal material. The external chamber 120 has a hollow shape having an accommodation space that accommodates the internal chamber 110. The external chamber 120 also has an outer door (not illustrated) provided at a lower portion thereof, and the outer door may be lowered together with the inner door to open the accommodation space. The internal chamber 110 may be mounted on the external chamber 120.

The gas supply module 130 is configured to supply gas to the internal chamber 110 and the external chamber 120. The gas supply module 130 may have a gas supplier 131 that communicates with a utility (gas supply facility) of a substrate processing plant. The gas supplier 131 may selectively provide processing gases, for example, hydrogen gas (H₂), deuterium gas (D₂), gaseous hydrogen oxide, fluorine gas (F₂), ammonia gas (NH₃), chlorine gas (Cl₂), nitrogen gas (N₂), etc., to the internal chamber 110. The gaseous hydrogen oxide may be used for wet oxidation, atomic layer deposition (ALD), chemical vapor deposition (CVD), annealing, etc. The gas supplier 131 may provide, as a protective gas, for example, nitrogen gas or argon gas (Ar) which is an inert gas, to the external chamber 120. The processing gas and the protective gas may be simply referred to as the process gas. The processing gas is supplied to the internal chamber 110 or the external chamber 120 through a processing gas line 133 or a protective gas line 135. The protective gas supplied to the external chamber 120 is specifically supplied to the remaining space (protection space) excluding a space occupied by the internal chamber 110 among the external chamber 120.

The processing gas may be supplied at a pressure higher than an atmospheric pressure (high pressure), and may be supplied to form a pressure reaching, for example, several atm to several tens of atm in the chambers 110 and 120. The processing pressure, which is the pressure of the processing gas, and the protective pressure, which is the pressure of the protective gas, may be maintained in a set relationship. For example, the protective pressure may be set to be substantially the same as or slightly greater than the processing pressure. This pressure relationship provides the advantage of preventing the processing gas from leaking from the internal chamber 110 and preventing the internal chamber 110 from being broken. The protective pressure may be set to be slightly lower than the processing pressure, and in that case, a similar effect as above may be achieved.

The gas exhaust module 140 is configured to exhaust the process gas. In order to exhaust the processing gas from the internal chamber 110, an exhaust pipe 141 is connected to an upper portion of the internal chamber 110. In order to exhaust the protective gas from the external chamber 120, an exhaust pipe 145 connected to the external chamber 120 may be similarly provided. Since these exhaust pipes 141 and 145 are integrated into one, the processing gas is diluted in the protective gas during the exhaust process, thereby lowering its concentration.

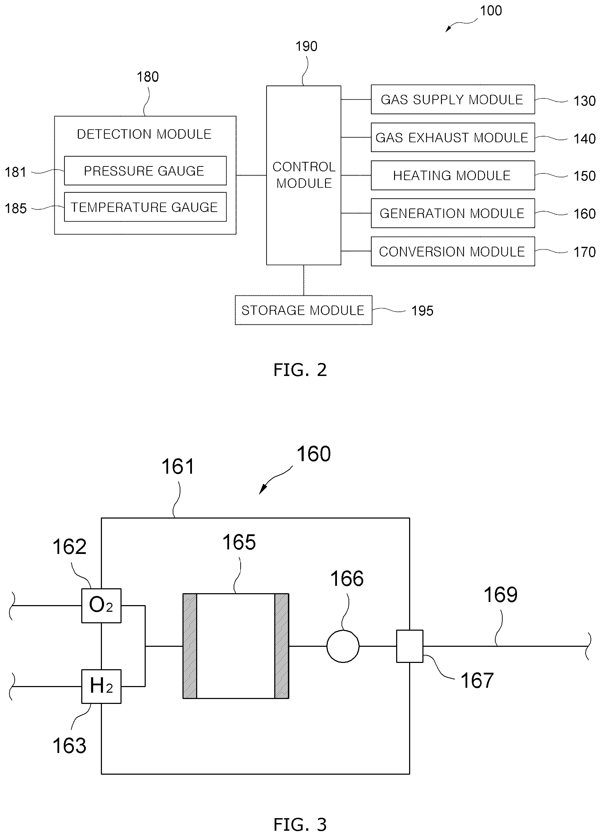

The control configuration of the high pressure substrate processing apparatus 100 is described with reference to FIG. 2. FIG. 2 is a block diagram for describing a control configuration of the high pressure substrate processing apparatus of FIG. 1.

Referring to this drawing (and FIG. 1), the high pressure substrate processing apparatus 100 may further include, in addition to the gas supply module 130 and the gas exhaust module 140 described above, a heating module 150, a generation module 160, a conversion module 170, a detection module 180, a control module 190, and a storage module 195.

The heating module 150 is configured to include the heater described above. The heater may be disposed within the external chamber 120 to direct the internal chamber 110.

The generation module 160 is configured to generate hydrogen oxide. The hydrogen oxide is a molecule in which oxygen and hydrogen are bonded, and may include H₂O, H₂O₂, H₂O₃, etc. The hydrogen oxide may be referred to as generated hydrogen oxide in that it is generated by the generation module 160. The generated hydrogen oxide may be gaseous hydrogen oxide in a gaseous state or liquid hydrogen oxide in a liquid state. The former may be referred to as generated gaseous hydrogen oxide, and the latter may be referred to as generated liquid hydrogen oxide. The generated hydrogen oxide has a generation pressure. The generation pressure may be higher than an atmospheric pressure, and specifically, may be several to several tens of atmospheres. The generation pressure may be lower than the processing pressure.

The conversion module 170 is configured to convert the generated hydrogen oxide into the gaseous hydrogen oxide (processed gaseous hydrogen oxide) that acts on the substrate in the processing area. To this end, the conversion module 170 may pressurize the generated hydrogen oxide so that the generation pressure increases to the processing pressure.

The conversion module 170 and the generation module 160 may be referred to as a high pressure gaseous hydrogen oxide providing device since they work cooperatively to provide high pressure gaseous hydrogen oxide (processed gaseous hydrogen oxide) to the processing area. The high pressure gaseous hydrogen oxide providing device may also operate in connection with the gas supply module 130. Specifically, the high pressure gaseous hydrogen oxide providing device may be installed in the processing gas line 133 or may be installed in communication with the processing gas line 133.

The detection module 180 is configured to detect the environment of the chambers 110 and 120. The detection module 180 may be provided with a pressure gauge 181 and a temperature gauge 185. The pressure gauge 181 and the temperature gauge 185 may be installed in each of the chambers 110 and 120. The detection module 180 may also have a gas detector (not illustrated) for detecting a specific gas.

The control module 190 is configured to control the gas supply module 130 and the gas exhaust module 140, etc. The control module 190 may control the operation of the gas supply module 130, etc., based on the detection result of the detection module 180.

The storage module 195 is configured to store data, programs, etc., that the control module 190 may refer to for control.

According to the configuration, the control module 190 may control the operation of the gas supply module 130 and the high pressure gaseous hydrogen oxide providing device based on the pressure of the chambers 110 and 120 obtained through the pressure gauge 181. According to the operation of the gas supply module 130 and the high pressure gaseous hydrogen oxide providing device, the processing gas may fill the processing area with the processing pressure. The protective space may be filled with the protective gas with the protective pressure.

The control module 190 may also control the operation of the gas exhaust module 140 based on the pressure of the chambers 110 and 120 obtained through the pressure gauge 181. According to the operation of the gas exhaust module 140, the processing gas may be exhausted from the processing area. The protective gas may be exhausted from the protective space.

The control module 190 may control the operation of the heating module 150 based on the temperature of the chambers 110 and 120 obtained through the temperature gauge 185. According to the operation of the heating module 150, the processing gas may reach a processing temperature for processing the substrate.

The specific configuration of the generation module 160 and the conversion module 170 will be described with reference to FIGS. 3 to 6. For convenience of description, H₂O is described as an example of the hydrogen oxide, but such description may be equally applied to H₂O₂, etc. The gaseous state of the H₂O is vapor, and the liquid state is water. Accordingly, the generated gaseous hydrogen oxide may be called generated vapor, and the generated liquid hydrogen oxide may be called generated water.

First, FIG. 3 is a conceptual diagram illustrating a generation module of FIG. 2.

Referring to this drawing, the generation module 160 is configured in a manner to produce gaseous hydrogen oxide (vapor) using gas as a starting material. The method using gas is different from the method of obtaining vapor using the liquid hydrogen oxide (water) as the starting material. The inventors have confirmed that, by adopting the method using gas, the generated H₂O does not contain impurities (silica).

The generation module 160 may specifically include a case 161, input units 162 and 163, a reaction unit 165, a detection unit 166, a discharge unit 167, and a guide line 169.

The case 161 is configured to have an inner space that accommodates the reaction unit 165, etc., to be described later. The case 161 may be manufactured in a sealed form so that there is no gas leakage. The gas leaked from the reaction unit 165, etc., inside the case 161 may be detected by a detector (not illustrated) and also may be exhausted while being pumped to the outside of the case 161. The internal space of the case 161 can be filled with an inert gas, for example, a nitrogen gas, or may be purged with the nitrogen gas.

The input units 162 and 163 are configured to receive gas from the gas supplier 131 (see FIG. 1). The oxygen gas (O₂) is input to one 162 of the input units 162 and 163, and the hydrogen gas (H₂) is input to the other one 163. If necessary, other substances may be additionally input to the input units 162 and 163 in addition to the oxygen gas and the hydrogen gas. A line supplying the hydrogen gas to the other one 163 may be formed as a dual pipe. The hydrogen gas may flow through an inner pipe of the dual pipe, and a detector (not illustrated) for detecting the leakage of the hydrogen gas may be installed in an outer pipe. When the leakage of the hydrogen gas occurs, the hydrogen gas may be exhausted from the inner space of the outer pipe. The exhaust facility for the hydrogen gas may be filled with, for example, an inert gas for explosion-proofing. The leakage of the hydrogen gas may be linked to the interlock of the high pressure substrate processing apparatus 100.

The reaction unit 165 is configured to react the oxygen gas and the hydrogen gas to produce the generated H₂O. The reaction unit 165 may maintain the temperature and pressure suitable for the reaction.

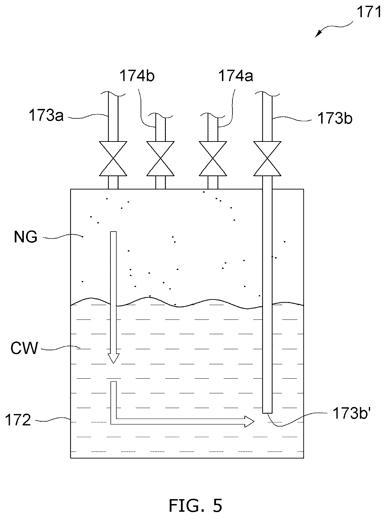

The detection unit 166 is configured to obtain the information related to the generated H₂O. The detection unit 166 may be configured to detect, for example, the temperature and pressure of the generated hydrogen oxide. The detection unit 166 may also detect the unreacted gas (NG, see FIG. 5). The unreacted gas NG refers to a gas that does not participate in the reaction among the oxygen gas and the hydrogen gas. Since the hydrogen gas as the unreacted gas NG has explosive power, it may require management.

The discharge unit 167 is configured to discharge a discharge matter. The inventor confirmed that the discharge matter is mainly composed of the generated H₂O below the reference pressure. The inventor also confirmed that the discharge matter may be slightly mixed with the unreacted gas NG above the reference pressure. The reference pressure may be, specifically, several atmospheres. The discharge matter may be a mixture in which the generated H₂O and the unreacted gas NG are mixed. Depending on the phase of the generated H₂O, the discharge matter may be a gas or a mixture of gas and liquid.

The guide line 169 is configured to guide the generated H₂O to the internal chamber 110. The guide line 169 may be the above-described processing gas line 133 (see FIG. 1) or may form a part thereof.

When only the gas (discharge gas) is discharged as the discharge matter, the conversion module 170 (see FIG. 2) may have an auxiliary gas line (not illustrated) for injecting the auxiliary gas into the internal chamber 110. The auxiliary gas is injected into the internal chamber 110 to increase the pressure of the generated H₂O, specifically, the generated vapor, and may form a part of the processing gas. The auxiliary gas may be, for example, an inert gas such as a nitrogen gas.

The auxiliary gas line may receive the auxiliary gas from the gas supplier 131 (see FIG. 1). The auxiliary gas line may be connected to a guide line 169 at a rear end of the case 161, and may supply the auxiliary gas to the internal chamber 110 through the guide line 169. In an alternative embodiment, the auxiliary gas line may be configured so that the auxiliary gas is mixed with the oxygen gas, the hydrogen gas, or the generated H₂O within the case 161.

According to this configuration, the generation module 160 discharges a discharge matter substantially composed only of the generated vapor with little unreacted gas NG as it operates below the reference pressure. Since such discharge matter has no concern about the unreacted gas NG, the generated vapor may be directly supplied to the internal chamber 110 without any other processing. However, since the generation pressure is lower than the processing pressure, the auxiliary gas may pressurize the generated vapor and convert the generated vapor into the processed vapor.

In an alternative embodiment, the generated vapor (with little unreacted gas NG) may be compressed by a compressor (not illustrated) before being injected into the internal chamber 110. In that case, the generated vapor may be pressurized to the processing pressure to become the processed vapor. The processed vapor may act on the substrate with the processing pressure without the help of the auxiliary gas.

Contrary to the above description, when the generation module 160 operates above the reference pressure, the discharge matter may include the unreacted gas NG together with the generated H₂O. In that case, the removal of the unreacted gas NG is required, and a new type of conversion module 170A may be adopted for this purpose.

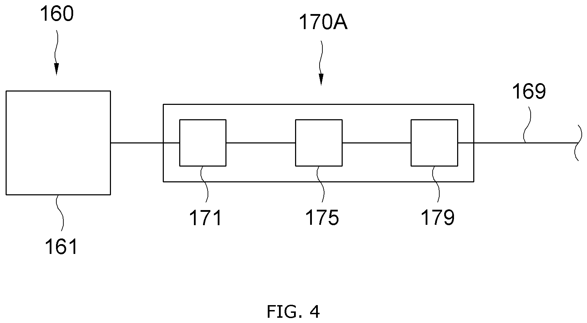

Next, FIG. 4 is a block diagram illustrating the generation module and the conversion module according to another embodiment of the present disclosure. In this drawing, the generation module 160 is the same as the above-described embodiment, so it is simply expressed as a box in the drawing.

With additional reference to this drawing, the conversion module 170A is configured to convert the generated H₂O into the processed vapor and also perform the removal of the unreacted gas NG during the conversion. To this end, the conversion module 170A may adopt a configuration that converts the phase of the generated H₂O (specifically, the generated vapor).

The conversion module 170A may include a water tank 171, a pump 175, and a vaporization heater 179.

The water tank 171 is configured to accommodate a resultant product as the discharge matter is liquefied. When the water tank 171 is disposed in a room temperature environment, the discharge matter may be liquefied in the water tank 171 without a separate cooling device. The resultant product includes condensed water CW (see FIG. 5) generated by liquefying the generated water vapor. The condensed water (condensed liquid hydrogen oxide) may be referred to as water (liquid hydrogen oxide) obtained from the generated H₂O (generated hydrogen oxide) together with the generated water (generated liquid hydrogen oxide). The resultant product may further include the unreacted gas NG. The specific configuration of the water tank 171 is described with reference to FIG. 5.

Referring back to the drawing, the pump 175 is configured to pump the condensed water CW. The condensed water CW may be pumped toward the processing area. The condensed water CW may also be pressurized by several or several tens of atmospheres and pumped. The pump 175 may be disposed between the water tank 171 and the vaporization heater 179.

The vaporization heater 179 is configured to vaporize the condensed water CW to generate water vapor (acquired water vapor). For this purpose, the vaporization heater 179 heats the condensed water CW. The acquired water vapor may be supplied to the processing area along the guide line 169 to become the processed vapor. The acquired water vapor may be further pressurized or mixed with the auxiliary gas to become the processed vapor. The above-described acquired vapor may be referred to as vapor (gaseous hydrogen oxide) obtained from the generated H₂O (generated hydrogen oxide), together with the generated vapor.

The vaporization heater 179 may be disposed outside the external chamber 120 (see FIG. 1). In an alternative embodiment, the vaporization heater 179 may be located inside the external chamber 120, i.e., in the protective space. In that case, the vaporization heater 179 may operate with less energy consumption since it is located in a higher temperature environment than the outside of the external chamber 120. In another alternative embodiment, the vaporization heater 179 is installed in the body of the internal chamber 110 (e.g., the inner door), and the condensed water CW may be vaporized by the vaporization heater 179 while flowing through the body to the processing area.

FIG. 5 is a cross-sectional diagram illustrating the water tank of FIG. 4.

Referring to this drawing, the water tank 171 may have a housing 172 defining the inner space. The discharge matter may be separated into the condensed water CW and the unreacted gas NG as it is liquefied and may be accommodated in the inner space. Specifically, the condensed water CW may be located at a lower portion of the inner space, and the unreacted gas NG may be located at an upper portion of the inner space. Since the unreacted gas NG and the condensed water CW are separated from each other, they occupy different spaces.

The discharge matter may be discharged to the housing 172 through a discharge line 173a. The condensed water CW may be sucked into the pump 175 through a suction line 173b. One end portion of the suction line 173b communicates with the pump 175, and the other end portion, a suction port 173b', may be disposed in the condensed water CW. As the suction port 173b' is disposed in the condensed water CW, the unreacted gas NG is not sucked into the pump 175 through the suction line 173b.

The condensed water CW is supplied to the internal chamber 110 through the pump 175 and the vaporization heater 179, but the unreacted gas NG is not supplied to the internal chamber 110 because it is separated from the condensed water CW. The unreacted gas NG may be discharged to an outside of an inner space through a discharge line 174a.

In order to more actively separate/remove the unreacted gas NG from the condensed water CW, a purge gas may be injected into the inner space through the injection line 174b. Since the purge gas purges the unreacted gas NG in the inner space, the unreacted gas NG may be discharged more smoothly through the discharge line 174a. The purge gas may be, for example, nitrogen gas, which is an inert gas.

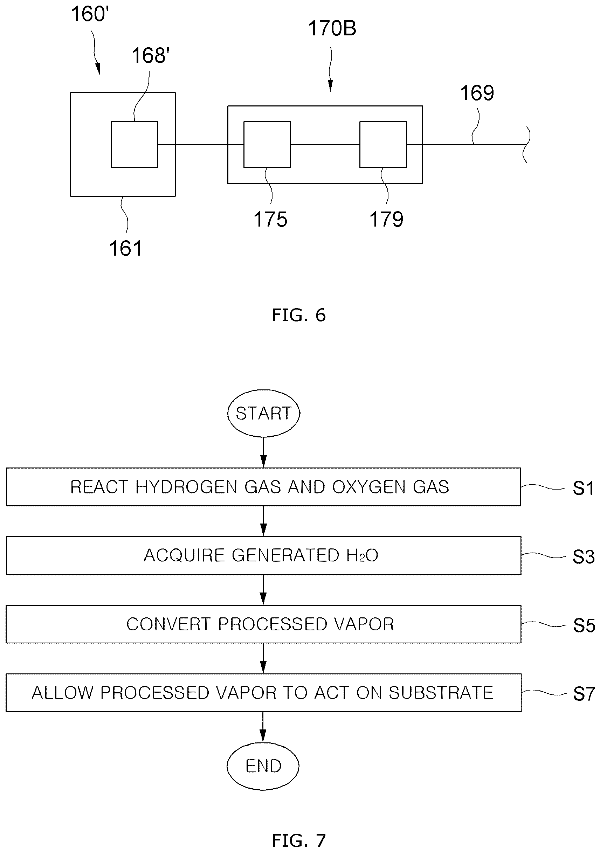

FIG. 6 is a conceptual diagram illustrating a generation module and a conversion module according to another embodiment of the present disclosure.

Referring to this drawing, a generation module 160' is substantially the same as the previous generation module 160 (see FIG. 4), but differs in that it has a water tank 168'. When the generated H₂O is the generated water, the water tank 168' may accommodate the generated water (and the unreacted gas). The water tank 168' may have substantially the same configuration as the previous water tank 171 (see FIG. 5).

A conversion module 170B is substantially the same as the preceding conversion module 170A, but differs in that it does not have the water tank 171.

According to this configuration, the discharge matter may include only the generated water, or the generated water and the unreacted gas. In the water tank 168', as described above, the separation of the generated water and the unreacted gas may be performed. The pump 175 may pressurize and pump the generated water from the water tank 168' to the vaporization heater 179. In the water tank 168', the purging of the unreacted gas may also be carried out.

Now, referring to FIGS. 7 to 9 (and FIGS. 1 to 6), a high pressure substrate processing method will be described.

FIG. 7 is a flowchart illustrating a high pressure substrate processing method according to still another embodiment of the present disclosure.

Referring further to this drawing, the control module 190 controls the generation module 160 to react the hydrogen gas and the oxygen gas (S1).

The generation module 160 discharges the discharge matter generated according to the reaction of the hydrogen gas and the oxygen gas. The discharge matter includes the generated H₂O having a first pressure (generation pressure) (S3).

The control module 190 controls the conversion module 170 to convert the generated H₂O into processed vapor having a second pressure (processing pressure) (S5). Specifically, the control module 190 may control the conversion module 170 to inject the auxiliary gas into the processing area, in addition to the generated H₂O (specifically, the generated vapor). The auxiliary gas causes the processing area to reach the second pressure, together with the generated vapor (first conversion method). The second pressure is a pressure higher than the first pressure and the atmospheric pressure, and may range from several atm to tens of atm, for example.

The processed vapor is allowed to act on the substrate in the processing area (S7). By the action of the processed vapor, wet oxidation, heat treatment, etc., are performed on the substrate.

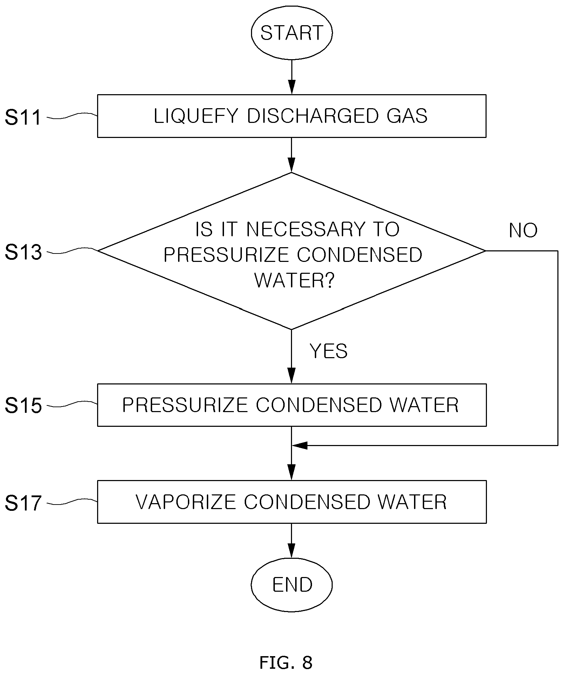

FIG. 8 is a flowchart illustrating a specific processing example related to one step of FIG. 6.

With additional reference to this drawing, the step (S5) of converting into the processed vapor may be performed in a manner using a phase change, unlike the above description.

Specifically, as the discharged gas is liquefied, the condensed water CW is obtained in the water tank 171 (S11).

The control module 190 determines whether the condensed water CW needs to be pressurized (S13). Such determination may vary depending on the pressure of the condensed water CW.

The control module 190 controls the pump 175 to pressurize the condensed water CW if necessary (S15). The pressurization of the condensed water CW may be performed before vaporized.

The control module 190 also controls the vaporization heater 179 to heat the condensed water CW (S17). The heated condensed water CW may become the processed vapor having the second pressure (second conversion method).

In an alternative embodiment, when the generated H₂O is the generated water, pressurization (S13 and S15) and vaporization (S17) may be performed on the generated water, not the condensed water.

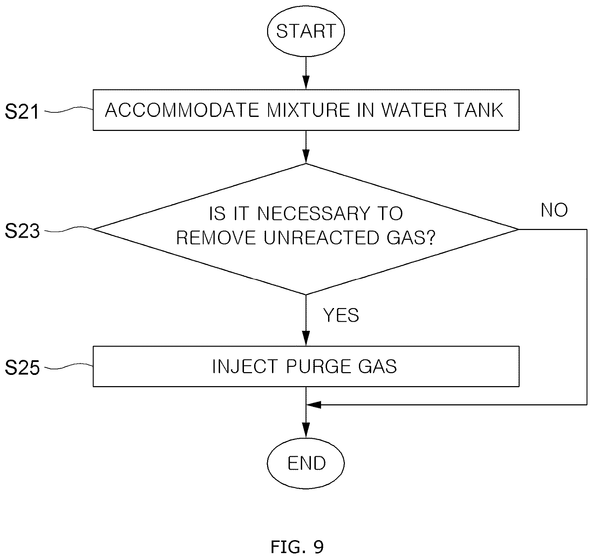

FIG. 9 is a flowchart illustrating another specific processing example related to one step of FIG. 6.

Referring to this drawing, the step (S5) of converting into the processed vapor also removes the unreacted gas NG.

Specifically, when the mixture is received in the water tanks 168' and 171, the unreacted gas NG may be separated from the generated water or the condensed water CW (S21).

The control module 190 determines whether the removal of the unreacted gas NG is necessary according to the amount of the unreacted gas NG (S23). When the unreacted gas NG is greater than the above-described reference amount, the control module 190 may determine that the removal of the unreacted gas NG is necessary.

For the active removal of the unreacted gas NG, the control module 190 may control the gas supply module 130 to inject the purge gas into the water tanks 168' and 171 (S25). As a result, the unreacted gas NG may be discharged to the outside from the water tanks 168' and 171. As a result, it may be ensured that the unreacted gas NG is not injected into the processing area.

In this specification, as the high pressure substrate processing apparatus 100, a processing apparatus having a dual chamber is described as an example, but the present disclosure is not limited thereto. The high pressure gaseous hydrogen oxide providing device may also be applied to a processing apparatus having a single chamber. The single chamber is composed of one housing and one door. The wafer substrate is disposed in the chamber, and the processing gas for processing the wafer substrate is also supplied thereto.

The configuration of the high pressure substrate processing apparatus 100 may also be applied to a semi-dual chamber, which is an intermediate form of the dual chamber and the single chamber. The semi-dual chamber may have two housings (inner housing and outer housing) and one door. The two housings may be combined by their own shapes or by intervening a separate member to form a closed space (corresponding to the protective space). As in the above-described embodiment, the substrate may be disposed in the processing area of the inner housing and the processing gas may be injected, and the protective gas may be injected into the closed space. Unlike the above-described embodiments, the door is not completely protected by the protective gas and is exposed to the outside. The door may correspond to the outer door in the above-described embodiment. The door may open and close the inner housing (and the outer housing).

Although the present disclosure is exemplified as a batch type processing apparatus, the present disclosure is not limited thereto. The present disclosure may also be applied to a single wafer type processing apparatus.

According to the high pressure gaseous hydrogen oxide providing device and the high pressure substrate processing apparatus and method using the same according to the present disclosure as described above, by reacting the hydrogen gas and the oxygen gas to obtain the generated hydrogen oxide having the first pressure, and then converting the generated hydrogen oxide into the processed gaseous hydrogen oxide having the second pressure higher than the first pressure and the atmospheric pressure and applying the processed gaseous hydrogen oxide to the substrate to be processed in the processing area, it is possible to eliminate risks that impurities such as silica contaminate the substrate in the high pressure process.

In addition, by preventing the unreacted gas that does not participate in the reaction of the hydrogen gas and the oxygen gas from being generated or removing the unreacted gas even if the unreacted gas is generated in the process of securing the gaseous hydrogen oxide, it is possible to prevent the risk of explosion due to the unreacted gas during the process.

## Claims

1. A high pressure substrate processing method, comprising:
reacting a hydrogen gas and an oxygen gas;
obtaining a generated hydrogen oxide having a first pressure;
converting the generated hydrogen oxide into a processed gaseous hydrogen oxide having a second pressure higher than the first pressure and an atmospheric pressure; and
allowing the processed gaseous hydrogen oxide to act on a substrate to be processed in a processing area.

2. The high pressure substrate processing method of claim 1, wherein the converting of the generated hydrogen oxide into the processed gaseous hydrogen oxide having the second pressure higher than the first pressure and the atmospheric pressure includes injecting an auxiliary gas into the processing area in addition to the gaseous hydrogen oxide obtained from the generated hydrogen oxide so that the gaseous hydrogen oxide obtained from the generated hydrogen oxide in the processing area reaches the second pressure.

3. The high pressure substrate processing method of claim 1, wherein the converting of the generated hydrogen oxide into the processed gaseous hydrogen oxide having the second pressure higher than the first pressure and the atmospheric pressure includes:
obtaining a liquid hydrogen oxide from the generated hydrogen oxide;
pressurizing the liquid hydrogen oxide; and
vaporizing the pressurized liquid hydrogen oxide to obtain the processed gaseous hydrogen oxide.

4. A high pressure substrate processing apparatus, comprising:
an internal chamber that is formed to accommodate a processing gas including a processed gaseous hydrogen oxide and having a processing pressure higher than an atmospheric pressure, and a substrate to be processed by the processing gas;
an external chamber that is formed to accommodate the internal chamber and a protective gas having a protection pressure set in relation to the processing pressure;
a generation module that is formed to react a hydrogen gas and an oxygen gas to generate a generated hydrogen oxide having a generation pressure lower than the processing pressure; and
a conversion module that is formed to pressurize the generated hydrogen oxide to convert the generated hydrogen oxide into the processed gaseous hydrogen oxide having the processing pressure.

5. The high pressure substrate processing apparatus of claim 4, wherein the conversion module includes an auxiliary gas line that is formed to inject an auxiliary gas into the internal chamber in addition to gaseous hydrogen oxide obtained from the generated hydrogen oxide so that the gaseous hydrogen oxide obtained from the generated hydrogen oxide in the internal chamber reaches the processing pressure.

6. The high pressure substrate processing apparatus of claim 4, wherein the conversion module includes a vaporization heater that is formed to vaporize liquid hydrogen oxide obtained from the generated hydrogen oxide to generate the processed gaseous hydrogen oxide.

7. The high pressure substrate processing apparatus of claim 6, wherein one of the generation module and the conversion module further includes a water tank that is formed to accommodate the liquid hydrogen oxide obtained from the generated hydrogen oxide and communicates with the vaporization heater.

8. The high pressure substrate processing apparatus of claim 7, wherein the conversion module further includes a pump that is disposed between the water tank and the vaporization heater and formed to pressurize and pump the liquid hydrogen oxide obtained from the generated hydrogen oxide toward the internal chamber.

9. The high pressure substrate processing apparatus of claim 7, wherein the conversion module further includes:
a discharge line that is formed to discharge an unreacted gas not participating in the reaction among the hydrogen gas and the oxygen gas from the water tank; and
an injection line that is formed to inject a purge gas for purging the unreacted gas into the water tank.

10. The high pressure substrate processing apparatus of claim 6, further comprising:
a heating module that is disposed within the external chamber to heat the processing gas to a processing temperature,
wherein the vaporization heater is disposed within the external chamber.

11. A high pressure gaseous hydrogen oxide providing device for a high pressure substrate processing apparatus, comprising:
a generation module that is formed to react a hydrogen gas and an oxygen gas to generate generated hydrogen oxide having a generation pressure lower than a processing pressure for processing a substrate to be processed in the high pressure substrate processing apparatus; and
a conversion module that is formed to pressurize the generated hydrogen oxide to convert the generated hydrogen oxide into the processed gaseous hydrogen oxide having the processing pressure,
wherein the processing pressure is a pressure higher than an atmospheric pressure.

12. The high pressure gaseous hydrogen oxide providing device of claim 11, wherein the conversion module includes an auxiliary gas line that is formed to inject auxiliary gas into a processing area in which the substrate to be processed is disposed in the high pressure substrate processing apparatus in addition to gaseous hydrogen oxide obtained from the generated hydrogen oxide so that the gaseous hydrogen oxide obtained from the generated hydrogen oxide in the processing area reaches the processing pressure.

13. The high pressure gaseous hydrogen oxide providing device of claim 11, wherein the conversion module includes a vaporization heater that is formed to vaporize liquid hydrogen oxide obtained from the generated hydrogen oxide to generate the processed gaseous hydrogen oxide.

14. The high pressure gaseous hydrogen oxide providing device of claim 13, wherein one of the generation module and the conversion module further includes a water tank that is formed to accommodate the liquid hydrogen oxide obtained from the generated hydrogen oxide and communicates with the vaporization heater.

15. The high pressure gaseous hydrogen oxide providing device of claim 14, wherein the conversion module further includes a pump that is disposed between the water tank and the vaporization heater and formed to pressurize and pump the liquid hydrogen oxide obtained from the generated hydrogen oxide toward the internal chamber.
